Europäisches Patentamt

European Patent Office

Office européen des brevets

(19)

(11) Publication number: **0 134 069**
**B1**

(12) **EUROPEAN PATENT SPECIFICATION**

(45) Date of publication of patent specification: **21.03.90**

(51) Int. Cl.[5]: **H 01 L 29/205, H 01 L 29/72**

(21) Application number: **84302952.1**

(22) Date of filing: **02.05.84**

(54) Bipolar transistor having a heterojunction between base and collector.

(30) Priority: **17.05.83 JP 86071/83**

(43) Date of publication of application:
**13.03.85 Bulletin 85/11**

(45) Publication of the grant of the patent:
**21.03.90 Bulletin 90/12**

(84) Designated Contracting States:
**DE FR GB NL**

(56) References cited:
**DE-A-2 847 451**
**ELECTRONICS LETTERS, vol. 19, no. 4, 17th February 1983, pages 128,129, London, GB; S.L. SU et al.: "Molecular beam epitaxial double heterojunction bipolar transistors with high current gains"**
**SOLID-STATE ELECTRONICS, vol. 18, 1975, pages 263-266, Oxford, GB; D.T. CHEUNG et al.: "A simplified model for graded-gap heterojunctions"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Yoshida, Jiro**
**2-1-13-401, Konandai Konan-ku**
**Yokohama-shi (JP)**
Inventor: **Kurata, Mamoru**
**3-17-4-209, Soshigaya Setagaya-ku**
**Tokyo (JP)**

(74) Representative: **Freed, Arthur Woolf et al**
**MARKS & CLERK 57-60 Lincoln's Inn Fields**
**London WC2A 3LS (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a heterojunction semiconductor device and, more particularly, to a bipolar transistor provided with a heterojunction formed between base and collector regions.

Recently, a noticeable development has been made in the heterojunction semiconductor devices constructed by bonding together different kinds of semiconductor materials due to the progress in molecular beam epitaxy (MBE) or in metal-organic chemical vapor deposition (MOCVD). The heterojunction bipolar transistor is known to offer more advantages than the conventional homojunction transistor made of a single semiconductor material. These advantages may be broadly classified into those realized by forming a heterojunction between emitter and base regions of a transistor and those derived from providing a heterojunction between base and collector regions of the transistor. The so-called wide-gap emitter structure obtained by forming a heterojunction between the emitter and base regions of the transistor offers the following advantages:

a1: The emitter efficiency can be elevated, even if the impurity concentration of the emitter region bears a small ratio to that of the base region.

a2: Since the base region is allowed to have a large impurity concentration, the base resistance can be reduced.

a3: Since the emitter region is allowed to have a small impurity concentration, the emitter capacitance can be decreased.

On the other hand, a wide-gap collector structure obtained by preparing a collector region from a material having a broader energy gap than the base region has the following advantages:

b1: Since, in the saturation region, minority carriers are prevented from being injected from the base region into the collector region, the storage region for the excess carriers can be reduced in size.

b2: When minority carriers are prominently injected, the base push-out effect is restricted, thereby enabling the storage region for the excess carriers to be decreased in size.

The heterojunction bipolar transistor having the above-mentioned merits has been found to be far more excellent than the conventional homojunction bipolar transistor in respect of its high frequency and switching characteristics. However, if in the case of an npn transistor having a wide-gap collector structure, an abrupt heterojunction is formed by directly connecting the wide-gap collector to the base region, then an energy barrier $\Delta Ec$ is produced in the conduction band in the heterojunction. The occurrence of the energy barrier $\Delta Ec$ arises from the discontinuity of the conduction band. The energy barrier $\Delta Ec$ obstructs the transport of electrons from the emitter region to the collector region. This fact eventually leads to a decline in the transport factor of the base region and to the loss of the DC characteristic of the transistor. The DC characteristic can be effectively prevented from falling by adopting a grading layer structure allowing energy gaps to slowly vary from the base region to the collector region, instead of providing an abrupt heterojunction between the base and collector regions. This is because the barrier in the conduction band has a smaller height than that of the abrupt heterojunction.

The energy barrier $\Delta Ec$ in the grading layer structure has already been discussed in various treatises, for example, in "Heterostructure Bipolar Transistors and Integrated Circuits" by H. Kroemer, Proceedings of the IEEE, vol. 70, No. 1, pp. 13—25, January, 1982 and in "A Simplified Model for Graded-Gap Heterojunctions" by D. T. Cheung et al, Solid-State Electronics, vol. 18, pp. 263—266, 1975. However, the publications known to date have given no clear hints as to what condition should be retained by a region in which the energy gap varies from the collector region to the base region.

The region in which the energy gap varies from the collector region to the base region is referred to as "transition region" hereinafter.

It is, accordingly, an object of this invention to provide a heterojunction bipolar transistor of a wide-gap collector structure having improved DC charactersitics.

To attain the above-mentioned object, a heterojunction bipolar transistor of this invention comprises: an n-type emitter region; a p-type base region comprising a region which is formed of a first kind of semiconductor material and defines the pn junction with the emitter region; and a n-type collector region which is formed of a second kind of semiconductor material and defines a heterojunction with the base region, the collector region having a wider energy gap than the base region and producing an energy barrier $\Delta Ec[eV]$ in the conduction band in the heterojunction, a transition region having a thickness Wt [cm] is formed in the heterojunction defined between the base region and collector region wherein the semiconductor material composition gradually varies, and the energy gap varies, said transition region being included in a depletion layer which is formed by a built-in voltage said transition region extending over at least said base region (114), between said base region and collector region, and the relationship between said energy barrier $\Delta Ec$ and the width Wt (cm) of said transition region being given by:—

$$\frac{\Delta Ec}{Wt} \leq \frac{q}{\varepsilon 1} \Gamma 1 \qquad (1)$$

$$\frac{\Delta Ec}{Wt} \leq \frac{q}{\varepsilon 2} \Gamma 2 \qquad (2)$$

where:

q=elementary charge [C]

$\varepsilon 1$=dielectric constant [Farad/cm] of the first kind of semiconductor material

$\varepsilon 2$=dielectric constant [Farad/cm] of the second kind of semiconductor material

$\Gamma 1$=total amount of effective acceptors in that portion of the base side depletion layer which is not included in the transition region

$\Gamma 2$=total amount of the effective donors in that portion of the collector side depletion layer which is not included in the transition region.

The heterojunction bipolar transistor of this invention constructed as described above has improved DC characteristics as well as advantages offered by the wide gap collector structure. The subject heterojunction bipolar transistor stands above conventional homojunction bipolar transistors in respect of its high frequency and switching characteristics.

The objects and advantages of this invention will be apparent from the following description taken in conjunction with the accompanying drawings, in which:

Fig. 1 illustrates the energy band profile of a heterojunction having a transition region, with no consideration given to the redistribution of electric charges;

Fig. 2 shows an energy band profile of a heterojunction having a transition region with the redistribution of the electric charges taken into account;

Fig. 3 shows the distribution of an electric field in the depletion layer of a heterojunction having a conventional transition region;

Fig. 4 indicates the distribution of an electric field in the depletion layer of a heterojunction having a transition region embodying this invention; and

Figs. 5 and 6 are cross-sectional views of heterojunction bipolar transistors according to embodiments of this invention.

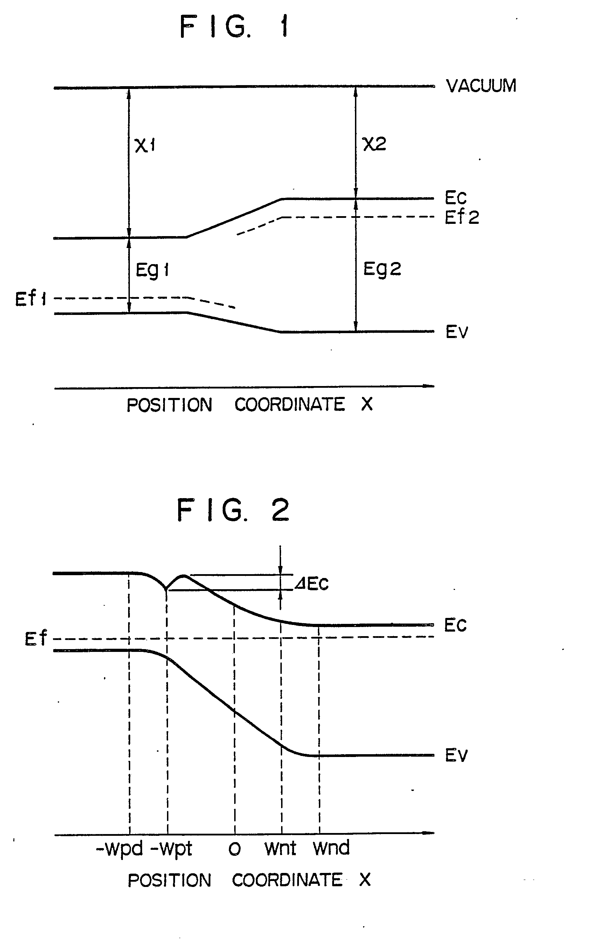

If two kinds of semiconductor materials are connected so as to provide a transition region between the materials, and the redistribution of electric charges between these semiconductor materials is not taken into account, then an energy band as shown in Fig. 1 is obtained with respect to the position coordinate x due to the differences between the electron affinities $\chi 1$ and $\chi 2$, and the energy gaps Eg1 and Eg2. Referring to Fig. 1, Ef1 and Ef2 respectively denote the Fermi levels of the semiconductor materials. Ec and Ev respectively represent the energy levels of a conduction band and a valence band. A heterojunction bipolar transistor embodying this invention uses a wide energy gap region as a collector region and a narrow energy gap region as a base region. Now let it be assumed that the narrow energy gap region is of p-type and the wide energy gap region is of n-type. Then the conduction band and valence band have their profiles changed from those of Fig. 1 to those of Fig. 2 due to the redistribution of the electric charge resulting from the formation of the pn junction. Fig. 2 shows the condition of the conduction band and valence band when the pn junction is depleted due to the effect of inverse voltage or built-in voltage. Referring to Fig. 2, the origin of the position coordinate x is chosen to the position of the pn junction. The position coordinate is defined as positive in the direction of the wide energy gap region. Now let it be assumed that Wnd denotes the edge of depletion layer formed at the collector region, and −Wpd represents the edge of depletion layer formed at the base region. Further let it be supposed that −Wpt denotes the base-side edge of the transition region where the energy gap slowly varies, and Wnt the collector-side edge of the transition region.

A detailed description may now be made, with reference to Fig. 2, of a heterojunction bipolar transistor embodying this invention. Now consider the potential $\psi$ expressed by equation (3) which equivalently represents the shape of a conduction band.

$$\psi(x)=-\frac{Ec(x)}{q} \tag{3}$$

where:

Ec(x)=energy of the conduction band

q=electric elementary charge

$\psi(x)$ denotes the sum of electrostatic potential $\psi e(x)$ resulting from the distribution of electric charge and potential $\psi s(x)$ caused by changes in the band structure.

Thus,

$$\psi(x)=\psi e(x)+\psi s(x) \tag{4}$$

Since $\psi e(x)$ is the potential determined by the distribution of electric charge, if the absolute depletion layer approximation is applied to determine $\psi e(x)$ for a pn junction impressed with inverse voltage, then the following Poisson's equation (5) should be satisfied.

$$\frac{d^2\psi e(x)}{dx^2} = -\frac{q}{\varepsilon(x)}Nd(x) \qquad (0\leqq x\leqq Wnd)$$

$$\frac{d^2\psi e(x)}{dx^2} = \frac{q}{\varepsilon(x)}Na(x) \qquad (-Wpd\leqq x\leqq 0)$$

$$\left. \right\} \qquad (5)$$

where:

$\varepsilon(x)$=the dielectric constant of a semiconductor material at the position $x$

$Nd(x)$, $Na(x)$=the respective densities of ionized donors and acceptors.

If an electric field $Ee(x)$ corresponding to changes in the potential $\psi e(x)$ is defined as

$$Ee(x) = -\frac{d\psi e(x)}{dx} \qquad (6)$$

then the Poisson's equation (5) may be rewritten as follows:

$$\frac{dEe(x)}{dx} = \frac{q}{\varepsilon(x)}Nd(x) \qquad (0\leqq x\leqq Wnd)$$

$$\frac{dEe(x)}{dx} = -\frac{q}{\varepsilon(x)}Na(x) \qquad (-Wpd\leqq x\leqq 0)$$

$$\left. \right\} \qquad (7)$$

$Ee(x)=0$ is obtained in each of the following conditions:

$$x=Wnd$$

$$x=Wpd$$

Solving equation (7) by using the said conditions results:

$$Ee(x) = -\int_0^{Wnd} q\frac{Nd(y)}{\varepsilon(y)}dy + \int_0^x q\frac{Nd(y)}{\varepsilon(y)}dy \qquad (0\leqq x\leqq Wnd)$$

$$Ee(x) = -\int_{-Wpd}^0 q\frac{Na(y)}{\varepsilon(y)}dy + \int_x^0 q\frac{Na(y)}{\varepsilon(y)}dy \qquad (-Wpd\leqq x\leqq 0)$$

$$\left. \right\} \qquad (8)$$

Now, let it be assumed an electric field corresponding to the potential $\psi s(x)$ resulting from changes in the band structure is expressed as follows:

$$Es(x) = -\frac{d\psi s(x)}{dx} \qquad (9)$$

A transition region is generally formed by progressively varying, over the range extending from the base region to the collector region, the mixed-crystal ratio between the first kind of semiconductor material forming the base region and the second kind of semiconductor material forming the collector region. For example, when the process of molecular beam epitaxy, is used for forming the transition region, it is most facile to linearly change the mixing ratio with respect to the position $x$. In this case, the shape of the condition band may be considered to change approximately linearly from the narrow energy gap region to the wide energy gap region. Therefore, the following equation (10) results:

$$Es(x) = \frac{\Delta Ec}{Wt} = \text{constant} \quad (-Wpt\leqq x\leqq Wnt) \qquad (10)$$

where:

$\Delta Ec$=the barrier height (measured in the unit of eV) in the conduction band when the wide energy gap collector and the narrow energy gap base are connected together without an intervening transition region

4

$$Wt = Wpt + Wnt \qquad (11)$$

(the total width of the transition region).

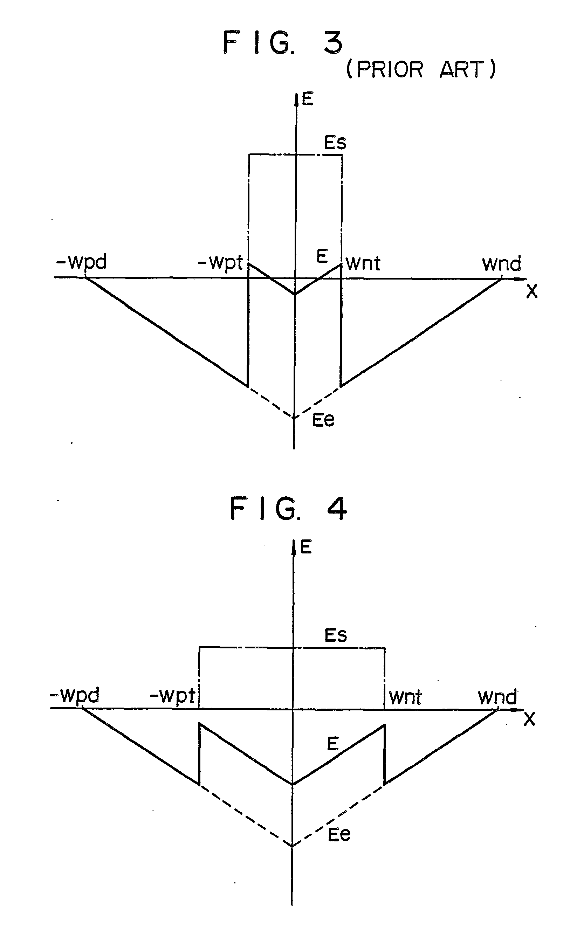

In an npn transistor having a heterojunction with a transition region formed between the base and collector regions, an electric field $E(x)$ acting on electrons moving from the emitter region to the collector region is expressed by the sum of equations (8) and (10). This composite electric field $E(x)$ is indicated by the solid lines shown in Fig. 3. The broken line given in Fig. 3 denotes the electric field Ee expressed by equation (8). The one dot-dash line represents the electric field Es expressed by equation (10). When the composite electric field $E(x)$ has a positive value, electrons are pushed back toward the emitter by the electric field. When, therefore, electrons injected from the emitter into the base region has to reach the collector region without undergoing a repulsive force, the composite electric field $E(x)$ should have a negative maximum value. If the transition region extends beyond the depletion region, it will be evident that a region in which the composite electric field $E(x)$ becomes positive appears, since the electric field Es is positive. Therefore, the first requisite condition of a heterojunction bipolar transistor embodying this invention is that a transition region defined between the base and collector regions should be included in the depletion layer which is produced when a prescribed inverse voltage is impressed between the base and collector regions.

When the transition region is included in the depletion region, a composite electric field $E(x)$ obtained on the collector side is expressed as follows:

$$\left. \begin{array}{l} E(x) = -\displaystyle\int_0^{Wnd} q\frac{Nd(y)}{\varepsilon(y)}dy + \int_0^x q\frac{Nd(y)}{\varepsilon(y)}dy + \frac{\Delta Ec}{Wt} \qquad (0 \leqq x \leqq Wnt) \\[4mm] E(x) = -\displaystyle\int_0^{Wnd} q\frac{Nd(y)}{\varepsilon(y)}dy + \int_0^x q\frac{Nd(y)}{\varepsilon(y)}dy \qquad (Wnt < x \leqq Wnd) \end{array} \right\} \qquad (12)$$

The second requisite condition of the subject heterojunction bipolar transistor is that the composite electric field $E(x)$ should be negative as seen from Fig. 4. Since the integration term of the above equation represents a monotonic increasing function, the composite electric field $E(x)$ obviously assumes its maximum value when $x = Wnt$. If this maximum composite electric field is expressed as $E_{max}^c$, then the following equation results:

$$E_{max}^c = -\int_{Wnt}^{Wnd} \frac{q}{\varepsilon(y)} Nd(y) dy + \frac{\Delta Ec}{Wt} \qquad (13)$$

Since the integration of equation (13) is carried out in the collector region lying beyond the collector side of the transition region, the dielectric constant $\varepsilon$ is not supposed to make any positional change. Thus, $\varepsilon(y) = \varepsilon 2$ (the dielectric constant of the second kind of semiconductor material forming the collector region). The condition that $E_{max}^c$ of equation (13) is negative is necessary for electrons injected from the emitter region to reach the collector region without undergoing a repulsive force. Eventually, therefore, the necessary condition for suppressing a drop in the transport factor of the base region may be given by

$$\frac{\Delta Ec}{Wt} \leqq \frac{q}{\varepsilon 2} \int_{Wnt}^{Wnd} Nd(y) dy \qquad (14)$$

The integration of the right side of equation (14) is equal to the total amount $\Gamma 2$ of the effective donors present in that portion of the collector-side depletion layer which is not included in the transition region. Therefore,

$$\frac{\Delta Ec}{Wt} \leqq \frac{q}{\varepsilon 2} \Gamma 2 \qquad (15)$$

If the same discussion as described above is applied to the base region, then

$$\frac{\Delta Ec}{Wt} \leqq \frac{q}{\varepsilon 1} \Gamma 1 \qquad (16)$$

where:

$\varepsilon 1 =$ the dielectric constant of the first kind of semiconductor material forming the base region

$\Gamma 1 =$ the total amount of effective acceptors present in that portion of the base side depletion layer extending from the pn junction to the base region which is not included in the transition region.

EP 0 134 069 B1

Equations (15), (16) represent a second requisite condition necessary to realize the heterojunction bipolar transistor of this invention. The elements included in equations (15), (16) are measured in the following units:

$\Delta Ec$ = the unit of [eV]

Wt = the unit of [cm]

q = the unit of [C] or Coulomb

$\varepsilon 1$ and $\varepsilon 2$ = the unit of [Farad/cm].

The aforementioned first and second requisite conditions of the subject heterojunction bipolar transistor define the upper and lower limits of the width Wt of the transition region. This will be discussed more practically hereinafter.

For the convenience of discussion, let it be assumed that the effective donor density of the collector side is fixed. Then equation (15) may be rewritten as follows:

$$\frac{\Delta Ec}{Wt} \leqq \frac{q}{\varepsilon 2} Nd(Wnd - Wnt) \qquad (17)$$

Further, the following equation results:

$$\frac{\Delta Ec}{Wt} = \frac{\Delta Ecn}{Wnt} \qquad (18)$$

where:

$\Delta Ecn$ = the barrier height in the conduction band when a stepped heterojunction is formed between a semiconductor material having the composition of the pn junction and the semiconductor material forming the collector region.

The following equation is derived from equations (17) and (18):

$$\frac{\Delta Ecn}{Wnt} \leqq \frac{q}{\varepsilon 2} Nd(Wnd - Wnt) \qquad (19)$$

When the above equation (19) is solved with respect to Wnt, the following equation results:

$$\frac{Wnd}{2}(1 + \sqrt{1 - \frac{4\varepsilon 2}{qNd} \cdot \frac{\Delta Ecn}{Wn^2 d}}) \geqq Wnt \geqq \frac{Wnd}{2}(1 - \sqrt{1 - \frac{4\varepsilon 2}{qNd} \cdot \frac{\Delta Ecn}{Wn^2 d}}) \qquad (20)$$

Namely, the upper and lower limits of the width of the transition region extending from the pn junction to the collector side may be determined from equation (20). An equivalent equation with respect to Wpt is also derived. Namely, an optimum design range can be defined with respect to the width of the transition region (Wt=Wnt+Wpt).

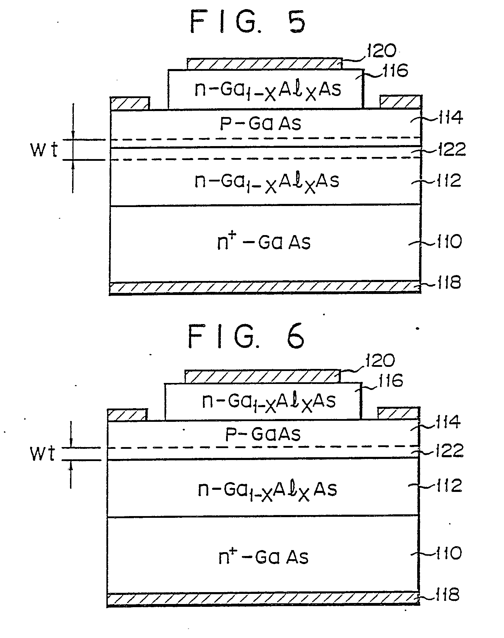

A description may now be made, with reference to Fig. 5, of a heterojunction bipolar transistor embodying this invention which prepares a wider-gap semiconductor material from $Ga_{1-x}Al_xAs$ and a narrow-gap semiconductor material from GaAs. Formed on an $n^+$-type GaAs substrate 110 is a collector region 112 formed of n-type $Ga_{1-x}Al_xAs$. Formed on the collector region 112 is a base region 114 of p-type GaAs. Formed on the base region 114 is an n-type emitter region 116 prepared from $Ga_{1-x}Al_xAs$. The GaAs substrate 110 is contacted by an electrode 118, and the emitter region 116 is contacted by an electrode 120. A transition region 122 having a width Wt is provided to extend over the collector region 112 and the base region 114. The transition region 122 is formed so as to satisfy equations (1) and (2).

A description may now be made of the method of manufacturing the heterojunction bipolar transistor. To fabricate such a bipolar transistor it is necessary to epitaxially grow the collector region 112, the base region 114 and the emitter region 116 on the electrically conducting or semi-insulating substrate 110 successively. In this embodiment, where $Ga_{1-x}Al_xAs$ is used as a collector material, GaAs is the optimum material for the substrate 110. The molecular beam epitaxy (MBE) process may be considered as acceptable in forming a transistor on the substrate 110. When the compositions of the various materials must be precisely controlled as in the structure of this invention, the MBE process proves most satisfactory. When the collector region 112 of the n-type $Ga_{1-x}Al_xAs$ is grown on the GaAs substrate 110, the flow rate of Ga, As and Al must be controlled and an impurity, for example, Si, should be introduced during the growth. Further, the flow rate of Al must also be controlled in the growth of the transition region 122 extending from the collector region 112 into the base region 114 in order to effect the slow change of the composition from $Ga_{1-x}Al_xAs$ to GaAs. In this case, the flow rate of Al has to be precisely controlled. In the embodiment of this invention, however, the thickness of the transition region 122 is more than several scores nm (several hundred Angstrom) units as described later. Therefore, the application of the MBE process ensures the control of the above-mentioned Al flow rate. Further, referring to the collector region 112 of $Ga_{1-x}Al_xAs$, the

6

energy gap changes substantially in proportion to the value of x which is less than 0.3. Therefore, by varying the flow rate of Al in proportion to the growth time, it is possible to form the transition region 122 wherein the energy gap varies substantially linearly. The p-type base region 114 of GaAs is formed similarly by the MBE process with Be, for example, used as the impurity. The n-type emitter region 116 is produced by the growth of $Ga_{1-x}Al_xAs$ while introducing an n-type impurity of silicon.

A concrete description may now be made of the method of designing the width Wt of the transition region 122 when the collector region 112 is prepared from $Ga_{0.7}Al_{0.3}As$ containing a silicon impurity concentration of $Nd=3\times10^{16}$ cm$^{-3}$ and when the base region 114 is formed of GaAs containing a beryllium impurity concentration of $Na=1\times10^{18}$ cm$^{-3}$. As seen from Fig. 5, the transition region 122 is formed in the collector region 112 and into the base region 114 and is doped into n-type with the silicon impurity concentration of $3\times10^{16}$ cm$^{-3}$.

Since, in this case, equation (2) is automatically satisfied when equation (1) is satisfied, it suffices to take equation (1) alone into account. In this case, equation (1) may be rewritten as follows:

$$\frac{\Delta Ec}{Wt} \leq \frac{q}{\varepsilon 2} Nd(Wnd-Wt) \tag{21}$$

Therefore, the requisite condition for the width Wt may be expressed as follows:

$$\frac{Wnd}{2}\left(1-\sqrt{1-\frac{4\varepsilon 2}{qNd}\cdot\frac{\Delta Ec}{Wn^2d}}\right)\leq Wt\leq \frac{Wnd}{2}\left(1+\sqrt{\frac{4\varepsilon 2}{qNd}\cdot\frac{\Delta Ec}{Wn^2d}}\right) \tag{22}$$

Considering the dielectric constant of the transition region 122 to have a value fully approaching that of the collector region 112, and using the absolute depletion layer approximation, the following relation results:

$$Wnd\approx\sqrt{\frac{2\varepsilon 2}{q}\cdot\frac{\varepsilon 2Na}{\varepsilon 1Nd^2+\varepsilon 2NaNd}(V+Vbi)} \tag{23}$$

where:

V=the prescribed reverse voltage applied between the base region 114 and collector region 112

Vbi=the built-in voltage between the base region 114 and collector region 112.

This voltage Vbi is expressed as follows:

$$Vbi\approx\chi_1-\chi_2+Eg1+\frac{kT}{q}\ln\frac{NaNd}{Nv1Nc2} \tag{24}$$

where:

$\chi_1, \chi_2$=the respective electron affinities [eV] in the base region 114 and collector region 112

Eg1=the energy gap [eV] in the base region 114

Nv1=the effective density [cm$^{-3}$] of the valence band of the base region 114

k=Boltzmann's constant

T=absolute temperature.

As seen from equation (23), the width Wnd is progressively widened as the reverse voltage V impressed between the base region 114 and collector region 112 is increased. As a result, a large lattitude is allowed in designing the width Wt expressed by equation (22). In the actual design, therefore, it is sufficient to set the width of the transition region at Wt as defined by equation (22) where V=0. When V=0 and T=300°K, substituting concrete numerical values into equations (22), (23) and (24) yields:

Vbi≈1.52 [V]

Wnd≈$2.55\times10^{-5}$ [cm]

Thus, the design condition for the width Wt is given by

$$29.5 \text{ nm (295 Å)} \leq Wt \leq 226 \text{ nm (2,260 Å)} \tag{25}$$

Therefore, the npn heterojunction bipolar transistor, which comprises the collector region 112 of $Ga_{0.7}Al_{0.3}As$ containing the silicon impurity concentration of $Nd=3\times10^{16}$ cm$^{-3}$ and the base region 114 of GaAs containing the beryllium impurity concentration of $Na=1\times10^{18}$ cm$^{-3}$, can be operated at a high speed without losing its DC characteristics, if the width of the transition region 122 falls within the range expressed by equation (25).

A description may now be made with reference to Fig. 6 of a heterojunction bipolar transistor according to a second embodiment of the invention. With this second embodiment, the transition region 122 having the width Wt is formed in the base region 114 alone. The other parts of the second embodiment of Fig. 6 are the same as those of the first embodiment of Fig. 5 and are denoted by the same numerals. With the second embodiment of Fig. 6, too, the transition region 122 is so formed as to satisfy equations (1),

7

(2). This second embodiment ensures a high speed operation without losing the DC characteristics as in the first embodiment of Fig. 5.

**Claims**

1. A heterojunction bipolar transistor comprising:
an n-type emitter region (116);
a p-type base region (114) comprising a region which is formed of a first kind of semiconductor material and defines a pn junction with said emitter region; and
an n-type collector region (112) which is formed of a second kind of semiconductor material and defines a heterojunction with said base region, said collector region having a wider energy gap than said base region, and producing an energy barrier $\Delta Ec$ [eV] in the conduction band in said heterojunction, a transition region with a thickness Wt [cm] being formed in said heterojunction between said base and collector regions in which the semiconductor material composition gradually varies and the energy gap varies, said transition region being included in a depletion layer formed by a built-in voltage, said transition region extending over at least said base region (114), between said base region and collector region, and the relationship between said energy barrier $\Delta Ec$ and the width Wt (cm) of said transition region being given by:

$$\frac{\Delta Ec}{Wt} \leqq \frac{q}{\varepsilon 1} \Gamma 1 \qquad (1)$$

$$\frac{\Delta Ec}{Wt} \leqq \frac{q}{\varepsilon 2} \Gamma 2 \qquad (2)$$

where:
q=elementary charge [C]
$\varepsilon 1$=dielectric constant [Farad/cm] of said first kind of semiconductor material
$\varepsilon 2$=dielectric constant [Farad/cm] of said second kind of semiconductor material
$\Gamma 1$=total amount of effective acceptors present in that portion of said depletion layer which is not included in said transition region and extends from said pn junction to the side of said base region
$\Gamma 2$=total amount of effective donors present in that portion of said depletion layer which is not included in said transition region and extends from said pn junction to the side of said collector region.

2. The heterojunction bipolar transistor according to claim 1, characterized in that said base region (114) is formed of GaAs and said collector region (112) is formed of $Ga_{1-x}Al_xAs$.

**Patentansprüche**

1. Heteroübergang-Bipolartransistor mit
einer n-(Typ-)Emitterzone (116),
einer p-(Typ-)Basiszone (114) aus einem Bereich bzw. einer Zone, der bzw. die aus einer ersten Halbleitermaterialart gebildet ist und mit der Emitterzone einen pn-Übergang festlegt, sowie
einer n-(Typ-)Kollektorzone (112), die aus einer zweiten Halbleitermaterialart gebildet ist und einen Heteroübergang mit der Basiszone festlegt, wobei die Kollektorzone einen größeren Bandabstand als die Basiszone aufweist und eine Energiebarriere $\Delta Ec$ [eV] im Leitungsband im Heteroübergang erzeugt, wobei im Heteroübergang zwischen Basis- und Kollektorzone eine Übergangs- oder Grenzschichtzone mit einer Dicke Wt (cm) gebildet ist, in welcher sich die Halbleitermaterialzusammensetzung allmählich ändert und der Bandabstand variiert, und die Übergangs- oder Grenzschichtzone in einer durch eine eingebaute Spannung gebildeten Verarmungsschicht enthalten ist und sich zwischen Basis- und Kollektorzone zumindest über die Basiszone (114) erstreckt, und die Beziehung zwischen der Energiebarriere $\Delta Ec$ und der Breite Wt (cm) der Übergangs- oder Grenzschichtzone sich durch folgende Formeln bestimmt:

$$\frac{\Delta Ec}{Wt} \leqq \frac{q}{\varepsilon 1} \Gamma 1 \qquad (1)$$

$$\frac{\Delta Ec}{Wt} \leqq \frac{q}{\varepsilon 2} \Gamma 2 \qquad (2)$$

in denen bedeuten:
q=Elementarladung (C)
$\varepsilon 1$=Dielektrizitätskonstante (Farad/cm) der ersten Halbleitermaterialart

ε2=Dielektrizitätskonstante (Farad/cm) der zweiten Halbleitermaterialart

Γ1=Gesamtmenge der wirksamen Akzeptoren in dem Bereich der Verarmungsschicht, der nicht in der Übergangs- oder Grenzschichtzone enthalten ist und sich vom pn-Übergang zur Seite der Basiszone erstreckt, (und)

Γ2=Gesamtmenge der wirksamen Donatoren in dem Bereich der Verarmungsschicht, der nicht in der Übergangs- oder Grenzshichtzone enthalten ist und sich vom pn-Übergang zur Seite der Kollektorzone erstreckt.

2. Heteroübergang-Bipolartransistor nach Anspruch 1, dadurch gekennzeichnet, daß die Basiszone (114) aus GaAs und die Kollektorzone (112) aus $Ga_{1-x}Al_xAs$ geformt sind.

## Revendications

1. Transistor bipolaire à hétérojonction, comprenant:

une région d'émetteur de type n (116);

une région de base de type p (114) comprenant une région qui est formée d'un matériau semiconducteur d'un premier type et qui définit une jonction pn avec ladite région d'émetteur; et

une région de collecteur de type n (112) qui est formée d'un matériau semiconducteur d'un deuxième type et qui définit une hétérojonction avec ladite région de base, ladite région de collecteur ayant une bande interdite d'énergie plus large que ladite région de base et produisant une barrière d'énergie $\Delta Ec$ [eV] dans la bande de conduction de ladite hétérojonction,

une région de transition d'épaisseur Wt [cm] étant formée dand ladite hétérojonction entre lesdites régions de base et de collecteur, dans laquelle la composition des matériaux semiconducteurs varie graduellement et la bande interdite d'énergie varie, ladite région de transition étant incluse dans une couche de déplétion formée par une tension intégrée, ladite région de transition s'étendant sur au moins ladite région de base (114), entre ladite région de base et ladite région de collecteur, et la relation entre ladite barrière dénergie $\Delta Ec$ et la largeur Wt [cm] de ladite région de transition étant donnée par:

$$\frac{\Delta Ec}{Wt} \leqq \frac{q}{\varepsilon 1} \Gamma 1 \qquad (1)$$

$$\frac{\Delta Ec}{Wt} \leqq \frac{q}{\varepsilon 2} \Gamma 2 \qquad (2)$$

où:

q est la charge élémentaire [C]

$\varepsilon 1$ est la constante diélectrique [F/cm] dudit matériau semiconducteur du premier type

$\varepsilon 2$ est la constante diélectrique [F/cm] dudit matériau semiconducteur du deuxième type

$\Gamma 1$ est la quantité totale d'accepteurs effectifs présents dans la partie de ladite couche de déplétion qui n'est pas incluse dans ladite région de transition et s'étend de ladite jonction pn jusqu'au côté de ladite région de base

$\Gamma 2$ est la quantité totale de donneurs effectifs présents dans la partie de ladite couche de déplétion qui n'est pas incluse dans ladite région de transition et s'étend de ladite jonction pn jusqu'au côté de ladite région de collecteur.

2. Transistor bipolaire à héterojonction selon la revendication 1, caractérisé en ce que ladite région de base (114) est formée de GaAs et ladite région de collecteur (112) est formée de $Ga_{1-x}Al_xAs$.

# F I G. 1

VACUUM

X1

X2

Ec
Ef2

Eg1

Eg2

Ef1

Ev

POSITION COORDINATE X

# F I G. 2

ΔEc

Ef

Ec

Ev

-wpd -wpt  O  wnt  wnd

POSITION COORDINATE X

1

# F I G. 3
(PRIOR ART)

# F I G. 4

# FIG. 5

| | |
|---|---|
| | 120 |
| | 116 |
| n-Ga$_{1-X}$Al$_X$As | |
| P-Ga As | 114 |
| Wt | 122 |
| n-Ga$_{1-X}$Al$_X$As | 112 |
| n$^+$-Ga As | 110 |
| | 118 |

# FIG. 6